(19) **Europäisches Patentamt / European Patent Office / Office européen des brevets**

(11) **EP 2 072 752 B1**

(12) **FASCICULE DE BREVET EUROPEEN**

(45) Date de publication et mention de la délivrance du brevet:
**18.03.2020 Bulletin 2020/12**

(51) Int Cl.:
*E21B 47/10* *(2012.01)* *G01V 11/00* *(2006.01)*

(21) Numéro de dépôt: **08291136.3**

(22) Date de dépôt: **01.12.2008**

(54) **MÉTHODE POUR OPTIMISER L'EXPLOITATION D'UN GISEMENT DE FLUIDE PAR PRISE EN COMPTE D'UN TERME D'ÉCHANGE GÉOLOGIQUE ET TRANSITOIRE ENTRE BLOCS MATRICIELS ET FRACTURES**

METHODE ZUR OPTIMIERUNG DER AUSBEUTUNG EINES FLUIDLAGERS DURCH BERÜCKSICHTIGUNG EINES GEOLOGISCHEN UND VORÜBERGEHENDEN AUSTAUSCHTERMS ZWISCHEN MATRIXBLÖCKEN UND BRÜCHEN

METHOD FOR OPTIMISING THE EXPLOITATION OF A FLUID RESERVOIR BY TAKING INTO CONSIDERATION A GEOLOGICAL AND TRANSITIONAL EXCHANGE TERM BETWEEN MATRIX BLOCKS AND FRACTURES

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **20.12.2007 FR 0709118**

(43) Date de publication de la demande:
**24.06.2009 Bulletin 2009/26**

(73) Titulaire: **IFP Energies nouvelles**
**92500 Rueil-Malmaison (FR)**

(72) Inventeur: **Bourbiaux, Bernard**
**92500 Rueil Malmaison (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
EP-A- 1 158 312   WO-A-2008/070526
FR-A- 2 757 957   FR-A- 2 858 444
US-A1- 2003 216 898

- **REZA NAIMI-TAJDAR ET AL.: "Matrix subgridding and its effec in dual porosity simulators" IPTC 11195, 4 décembre 2007 (2007-12-04), - 6 décembre 2007 (2007-12-06) XP008097256**
- **WARREN J E ET AL: "THE BEHAVIOR OF NATURALLY FRACTURED RESERVOIRS" SPE PAPERS, XX, XX, vol. 3, no. 3, 1 septembre 1963 (1963-09-01), pages 245-255, XP002058945**
- **SABATHIER J C ET AL: "A New Approach of Fractured Reservoirs" SOCIETY OF PETROLEUM ENGINEERS JOURNAL, DALLAS, TX, US, no. 39825, 3 mars 1998 (1998-03-03), pages 49-59, XP002269337 ISSN: 0197-7520**

## Description

La présente invention concerne le domaine de l'optimisation de l'exploitation de gisements souterrains, tels que des gisements d'hydrocarbures, notamment lorsque ceux-ci comportent un réseau de fractures.

La méthode selon l'invention, convient notamment pour l'étude des propriétés hydrauliques de terrains fracturés, et notamment pour étudier les déplacements d'hydrocarbures dans des gisements souterrains.

En particulier, l'invention concerne une méthode destinée à prédire les écoulements de fluides susceptibles de se produire à travers ce milieu, pour simuler une production d'hydrocarbures suivant divers scénarios de production.

L'industrie pétrolière, et plus précisément l'exploration et l'exploitation de gisements, notamment pétroliers, nécessitent d'acquérir une connaissance aussi parfaite que possible de la géologie souterraine pour fournir de façon efficace une évaluation des réserves, une modélisation de la production, ou la gestion de l'exploitation. En effet, la détermination de l'emplacement d'un puits de production ou d'un puits d'injection, la constitution de la boue de forage, les caractéristiques de complétion, le choix d'un procédé de récupération des hydrocarbures (tel que l'injection d'eau par exemple) et des paramètres nécessaires à la mise en oeuvre de ce procédé (tels que la pression d'injection, le débit de production,...) nécessitent de bien connaître le gisement. Connaître le gisement signifie notamment connaître les propriétés pétrophysiques du sous-sol en tout point de l'espace.

Pour ce faire, depuis longtemps, l'industrie pétrolière allie les mesures sur champ (in situ) aux modélisations expérimentales (réalisées au laboratoire) et/ou numériques (réalisées au moyen de logiciels). Les modélisations des gisements pétroliers constituent donc une étape technique indispensable à toute exploration ou exploitation de gisement. Ces modélisations ont pour but de fournir une description du gisement.

Les réservoirs fissurés constituent un type extrême de réservoirs hétérogènes comportant deux milieux contrastés, un milieu matriciel contenant la plus grande part de l'huile en place et présentant une faible perméabilité, et un milieu fissuré représentant moins de 1 % de l'huile en place et hautement conducteur. Le milieu fissuré lui-même peut être complexe, avec différents ensembles de fissures caractérisés par leur densité, longueur, orientation, inclinaison et ouverture respectives.

Les ingénieurs en charge de l'exploitation de réservoirs fracturés, ont besoin de parfaitement connaître le rôle des fractures. On appelle "*fracture*", une discontinuité plane, de très faible épaisseur par rapport à son extension, et qui représente un plan de rupture d'une roche du gisement. D'une part, la connaissance de la distribution et du comportement de ces fractures permet d'optimiser la localisation et l'espacement entre les puits que l'on compte forer au travers du gisement pétrolifère. D'autre part, la géométrie du réseau de fractures conditionne le déplacement des fluides tant à l'échelle du réservoir qu'à l'échelle locale où elle détermine des blocs matriciels élémentaires dans lesquels l'huile est piégée. Connaître la distribution des fractures, est donc très utile, aussi, à un stade ultérieur, pour l'ingénieur de réservoir qui cherche à calibrer les modèles qu'il construit pour simuler les gisements afin d'en reproduire ou prédire les courbes de production passées ou futures. A ces fins, les spécialistes de géosciences disposent d'images tridimensionnelles des gisements, permettant de localiser un grand nombre de fractures.

Ainsi, pour reproduire ou prédire (i.e. "simuler") la production d'hydrocarbures lors de la mise en production d'un gisement suivant un scénario de production donné (caractérisé par la position des puits, la méthode de récupération, ...), le spécialiste en ingénierie de réservoir met en oeuvre un logiciel de calcul, appelé « simulateur de réservoir » (ou « simulateur d'écoulement »), qui calcule les écoulements et l'évolution des pressions au sein du réservoir, les résultats de ces calculs lui permettant de prévoir et d'optimiser le gisement en termes de débit et/ou de quantité d'hydrocarbures récupérés. Le calcul du comportement du réservoir suivant un scénario de production donné constitue une « simulation de réservoir ».

## État de la technique

On connaît une méthode pour optimiser l'exploitation d'un gisement de fluide traversé par un réseau de fractures, dans laquelle on simule des écoulements de fluides dans le gisement au moyen d'une modélisation simplifiée mais réaliste du gisement. Cette représentation simplifiée est appelée "approche double milieu", elle est proposée par Warren J.E. et al. dans "The Behavior of Naturally Fractured Reservoirs", SPE Journal (septembre 1963), 245-255. Cette technique consiste à considérer le milieu fracturé comme deux continua échangeant des fluides entre eux : des blocs matriciels et des fractures. On parle alors de modèle « double milieu » ou « double porosité ». Ainsi, la modélisation en "double milieu" d'un gisement fracturé consiste à discrétiser ce gisement en deux ensembles de mailles (appelés grilles) superposés, constituant la grille "fissure" et la grille "matrice". Chaque volume élémentaire du gisement fracturé est ainsi conceptuellement représenté par deux mailles, l'une "fissure" et l'autre "matrice", couplées entre elles (c'est-à-dire échangeant des fluides). Dans la réalité du champ fracturé, ces deux mailles représentent l'ensemble des blocs matriciels délimités par des fractures présents en cet endroit du réservoir. En effet, le plus souvent, les mailles ont des dimensions latérales hectométriques (couramment 100 ou 200 m) compte tenu de la taille des champs et des possibilités limités des logiciels de simulation en termes de capacité et temps de calcul. Il en résulte que, pour la plupart des champs fracturés, le volume élémentaire (maille) de réservoir fracturé renferme d'innombrables fractures formant un réseau complexe délimitant de multiples blocs matriciels de dimensions et formes variables suivant le contexte géologique. Chacun des blocs réels constitutifs échange des fluides avec les fractures qui l'entourent à un rythme (débit) qui lui est propre car dépendant des dimensions et de la forme de ce bloc particulier.

Face à une telle complexité géométrique du milieu réel, la démarche consiste, pour chaque volume élémentaire (maille) de réservoir, à représenter le milieu fracturé réel comme un ensemble de blocs matriciels tous identiques, parallélépipédiques, délimités par un réseau orthogonal et régulier de fractures orientées suivant les directions principales d'écoulement : pour chaque maille, on définit ainsi un bloc matriciel, dit « représentatif » (de la distribution réelle (géologique) des blocs), unique et de forme parallélépipédique. Il est alors possible de formuler et calculer les flux d'échange matrice-fissure pour ce bloc "représentatif", et d'en multiplier le résultat par le nombre de tels blocs dans le volume élémentaire (maille) pour obtenir le flux à l'échelle de cette maille.

Dans la version "simple perméabilité" du modèle double milieu, l'écoulement des fluides à l'échelle du réservoir, est supposé ne s'effectuer que via les fractures (i.e. via la seule grille fracture), des échanges de fluides intervenant localement entre les fractures et les blocs matriciels (i.e. entre les deux mailles d'un couple donné de mailles "fracture" et matrice représentant le réservoir poreux fracturé en un endroit donné du champ). Dans la version "double perméabilité" de ce même modèle, l'écoulement des fluides s'opère au sein des deux milieux "fracture" et "matrice" à l'échelle du réservoir, avec toujours des échanges fracture-matrice locaux de fluides intervenant localement entre les fractures et les blocs matriciels

Une telle représentation (modélisation) du réservoir fracturé réel (géologique) est utilisée pour reproduire, i.e. "simuler", la réponse (le comportement) du champ lors de sa mise en production. Pour ce faire, des équations d'écoulement ou transfert sont formulées, explicitées et résolues pour chacune des mailles constitutives du modèle suivant la méthode résumée ci-après : l'ensemble des équations mathématiques appliquées au double milieu représentant le réservoir fracturé constitue le simulateur de réservoir double milieu, bien connu des spécialistes.

Un simulateur de réservoir permet, à partir de données d'entrées concernant d'une part les deux milieux (matrice et fracture), et d'autre part les fluides que ce double milieu contient, de déterminer, à divers instants ("pas de temps") et en chaque maille, les valeurs de divers paramètres quantifiant l'état de ces deux milieux tels que les saturations (en huile, gaz, eau), les pressions, les concentrations, les températures, ... Ce simulateur résout deux jeux d'équations, l'un relatif au milieu matriciel, et l'autre relatif au milieu fracturé. Pour mémoire, nous rappelons que ces équations expriment les bilans de masse (par constituant) et d'énergie pour chacune des mailles "fracture" et "matrice" représentant chacun des volumes élémentaires du réservoir réel : ces bilans de masse font intervenir des flux d'échange entre mailles du même milieu (fracture ou matrice) voisines dans l'espace, le terme d'échange matrice-fissure objet de la présente invention, un éventuel terme d'injection ou production si un puits traverse le volume élémentaire considéré, l'ensemble des termes de flux précédents étant égal au terme d'accumulation de matière ou d'énergie de la maille considérée). Ainsi, les équations relatifs au milieu "matrice" et au milieu "fracture" en chaque point du réservoir sont couplés, via un terme d'échange, décrivant les flux d'échange (de masse ou d'énergie) entre la roche (matrice) poreuse et les fractures qui la traversent : cette modélisation des échanges matrice - fracture est essentielle, car la matrice renferme le plus souvent l'essentiel des réserves à produire.

La méthode adoptée jusqu'à ce jour, pour formuler ces échanges matrice-fracture (ou matrice-fissure), consiste, pour chaque couple de mailles fracture et matrice discrétisant le modèle double milieu :

- d'une part à déterminer les dimensions de blocs matriciels identiques (en dimensions et forme) supposés représentatifs de la distribution réelle complexe des blocs présents dans ce volume élémentaire de réservoir ;

- puis à formuler et calculer le flux d'échange matrice-fissure en fonction des dimensions de ce bloc représentatif ainsi calculées (ce flux est alors égal au flux exprimé pour un tel bloc représentatif multiplié par le nombre de tels blocs dans la maille considérée).

Ainsi, les formulations d'échange adoptées à ce jour dans les simulateurs de réservoir fracturé, qui s'appuient sur une représentation très simplifiée de ce type de réservoir, s'avèrent très approximatives et incapables de rendre fidèlement compte de l'ensemble des mécanismes d'échange susceptibles d'être mis en jeu, qui comprennent la diffusivité de pression, la capillarité, la gravité, la diffusion moléculaire, la conduction et des forces visqueuses.

En effet, d'une part, l'échange entre blocs de matrice et fissures est exprimé à l'échelle de la maille (hectométrique) du modèle de simulation en considérant qu'un bloc matriciel de dimensions et forme fixées est représentatif de ("équivalent" à) l'ensemble des blocs réels (géologiques) de la maille.

D'autre part, l'échange est supposé pseudo-permanent c'est-à-dire que le flux d'échange aux limites de ce bloc équivalent est proportionnel à la différence de potentiel (ex.: la différence de pression, la différence de température, ...) entre les deux milieux matrice et fissure. Pour chaque milieu, ce potentiel (température par exemple) est supposé uniforme au sein d'un milieu donné, donc dans le cas présent uniforme (constant) au sein de chaque bloc représentatif de la maille considérée à l'instant de simulation considéré. Or, les échanges entre fissures et blocs, notamment s'ils impliquent plusieurs phases fluides, ne sont pas instantanés. De plus, en dehors des effets gravitaires et d'entraînement visqueux (par l'écoulement de fracture), ces échanges concernent d'abord la périphérie des blocs avant de se propager vers leur centre. Cette non-uniformité spatiale du changement d'état des blocs matriciels induit aussi une évolution temporelle non stationnaire, puisque le fluide de la fracture accède beaucoup plus rapidement aux bordures du bloc qu'à son centre. Une restitution fidèle du changement d'état des blocs nécessiterait ainsi de discrétiser le bloc afin d'y simuler les déplacements à une échelle locale (intra-bloc), la résultante de ces écoulements à la frontière bloc - fracture constituant alors une estimation beaucoup plus précise de l'échange matrice - fracture au cours du temps.

En outre, on connaît les demandes de brevet EP1158312 et US2003/216898 qui utilisent « l'approche double milieu ».

La demande de brevet EP1158312 décrit une méthode pour modéliser les flux dans un milieu fracturé. Pour cette méthode, on détermine les zones envahies par l'eau, dans le but de déterminer les dimensions de bloc matriciel équivalent.

La demande de brevet US2003/216898 décrit une méthode pour modéliser les flux de fluide dans un milieu poreux multicouches comprenant un réseau de fractures. Pour cette méthode, on calcule un flux d'échange constant entre blocs poreux et fractures

Ainsi, l'objet de l'invention concerne une méthode alternative pour optimiser l'exploitation d'un gisement de fluide traversé par un réseau de fractures, dans laquelle on détermine les termes d'échanges transitoires entre blocs matriciels et fractures, directement à partir des images géologiques des réseaux de fractures, afin de permettre une prévision la plus réaliste et fiable possible de la production de fluides renfermés dans des réservoirs poreux fracturés et/ou faillés.

**La méthode selon l'invention**

Selon l'invention, on discrétise le gisement en un ensemble de mailles et on associe à chacune de ces mailles, une image représentative du réseau de fractures délimitant des blocs poreux et des fractures, à partir d'observations directes et indirectes du gisement.

La méthode comporte les étapes telles que décrites dans les revendications.

Selon l'invention, on peut déterminer le flux d'échanges transitoires à partir de l'estimation d'une relation (A(X), V(X)) représentant, pour une maille donnée, une avancée d'un front d'échange au sein des blocs poreux, en fonction d'une distance d'avancée (X) du front. Cette relation peut représenter, pour une maille donnée, une aire de blocs poreux envahis par un fluide (application en deux dimensions), ou un volume de blocs poreux envahis par un fluide (application en trois dimensions).

On peut également simuler les écoulements de fluides, à partir d'un simulateur utilisant une méthode de résolution de type implicite, afin d'obtenir les résultats de simulation à chaque pas de temps t. Pour ce faire, on incorpore le flux d'échanges transitoires dans la méthode de résolution implicite au moyen des étapes suivantes :

- on exprime, à un pas de temps t, le flux d'échanges transitoires en fonction d'inconnues résolues par le simulateur à ce pas de temps t ;
- on exprime une dérivée de ce flux d'échanges transitoires par rapport aux inconnues du simulateur, et
- on incorpore cette dérivée dans un système d'équations du simulateur.

D'autres caractéristiques et avantages de la méthode selon l'invention, apparaîtront à la lecture de la description ci-après d'exemples non limitatifs de réalisations, en se référant aux figures annexées et décrites ci-après.

**Présentation succincte des figures**

- La figure 1 illustre la méthode d'optimisation selon l'invention, ainsi qu'une technique de simplification utilisée antérieurement.

- La figure 2 illustre une modélisation d'un réseau de fractures, constituant une image représentative du réseau réel de fractures délimitant les blocs matriciels.

- La figure 3 illustre la superposition des deux grilles, selon le modèle double milieu, ainsi que les différents échanges entre ces deux milieux.

## Description détaillée de la méthode

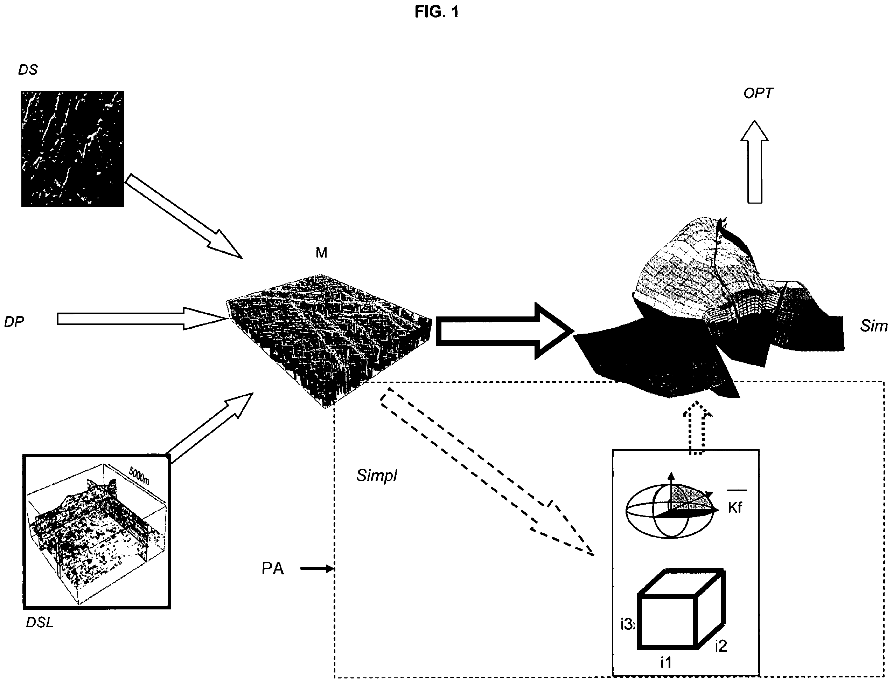

La méthode selon l'invention permet d'optimiser l'exploitation d'un gisement d'hydrocarbures, notamment lorsque celui-ci comporte un réseau de fractures. La figure 1 illustre la méthode. A partir de données sismiques (DS), de données de puits (DP), et de données sédimentaires et lithologiques (DSL), on construit un modèle géologique du gisement étudié, consistant en une représentation détaillée de sa réelle complexité interne. Ce modèle comporte un ensemble de maille. Chaque maille (M) contient une image du réseau de fracture. Sur la figure 1, la maille M, mesure 200m x 200m x 10m. Ce modèle forme un milieu poreux complexe, composé d'un ensemble de blocs matriciels poreux, de formes et tailles irrégulières. Chacun des blocs est délimité par des fractures.

Compte tenu de sa complexité géométrique, un tel modèle, bien que représentatif, ne peut être utilisé pour effectuer des prévisions de production du gisement. Il est indispensable de le simplifier en un modèle dit « équivalent ». On appelle « milieu équivalent » un milieu dont l'estimation de la récupération d'huile lors d'un processus de déplacement, tel que l'imbibition capillaire, est sensiblement la même que l'estimation de la récupération d'huile effectuée sur le milieu poreux complexe, i.e. représentatif des diverses formes et dimensions des blocs matriciels constituant le gisement considéré.

Ainsi, à partir de ce modèle géologique, selon l'art antérieur (PA), on construisait un modèle simplifié (simplification (Simpl) par équivalence à un modèle de type Warren & Root), dit « équivalent », constitué de blocs de dimensions et formes identiques qui possèdent les mêmes propriétés pétrophysiques et se comportent de manière équivalente en terme de récupération d'huile. Par exemple, le critère d'équivalence est fondé sur la récupération d'huile lors du processus d'imbibition capillaire des blocs mis enjeu lors d'une injection d'eau.

Selon l'invention, on s'affranchit de ce modèle équivalent pour calculer les flux d'échanges. On réalise alors des simulations d'écoulement (Sim), qui permettent de calculer des prévisions de production plus représentatives, plus fiables, plus précises, et plus nombreuses. L'invention permet de prendre des décisions de développement (OPT) moins risquées et plus rapidement.

La méthode comporte quatre étapes :

1- Discrétisation du gisement en un ensemble de mailles

2- Modélisation du réseau de fractures

3- Simulation des écoulements de fluides

4- Optimisation des conditions de production du gisement

### 1 - Discrétisation du gisement en un ensemble de mailles

Depuis longtemps, l'industrie pétrolière allie les mesures sur champ (in situ) aux modélisations expérimentales (réalisées au laboratoire) et/ou numériques (réalisées au moyen de logiciels).

Les modélisations des gisements pétroliers, constituent donc une étape technique indispensable à toute exploration ou exploitation de gisement. Ces modélisations ont pour but de fournir une description du gisement, caractérisée par la structure/géométrie et les propriétés pétrophysiques des dépôts ou formations géologiques qui le constituent.

Ces modélisations se basent sur une représentation du gisement, en un ensemble de mailles. Chacune de ces mailles représente un volume donné du gisement, et constitue un volume élémentaire du gisement. L'ensemble des mailles constitue une représentation discrète du gisement, appelée modèle géologique.

### 2- Modélisation du réseau de fractures

Pour prendre en compte le rôle du réseau de fractures dans la simulation des écoulements au sein du gisement, il est nécessaire d'associer à chacun de ces volumes élémentaires (mailles) une modélisation des fractures.

Ainsi, selon l'invention, on part d'un modèle géologique du gisement étudié, c'est-à-dire une représentation détaillée de la complexité interne du réseau de fractures aussi fidèle que possible des observations directes et indirectes du réservoir faites par les spécialistes en charge de la caractérisation du réservoir. Ce modèle constitue un milieu poreux complexe composé d'un ensemble de blocs matriciels poreux, de formes et tailles irrégulières, délimités par des fractures. Ce milieu poreux complexe constitue une image représentative du réseau réel de fractures délimitant les blocs matriciels.

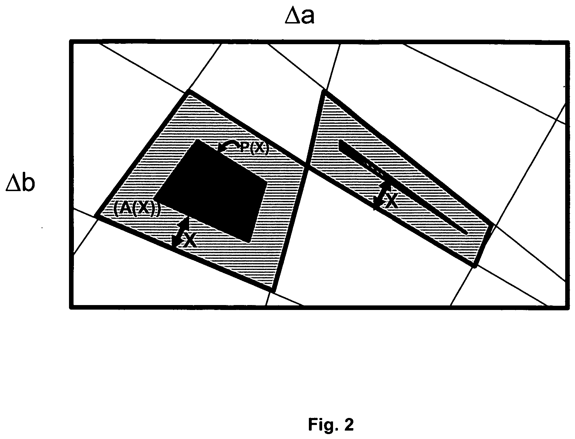

Pour mettre en œuvre une telle méthode, on peut utiliser des logiciels de modélisation, bien connus des spécialistes, tel que le logiciel FRACAFlow® (IFP, France). Une telle image est représentée sur la figure 2.

En raison de son extrême complexité géométrique, le modèle géologique précédent, représentatif du réservoir fracturé réel, ne peut être utilisé pour simuler, i.e. reproduire et/ou prédire, la production du gisement lors de la mise en œuvre d'un procédé de récupération, tel que l'injection d'eau par exemple.

Pour contourner cet obstacle, la méthode pratique existante consiste à simplifier ce modèle du milieu poreux complexe réel. Cette méthode repose sur l'approche, appelée "approche double porosité", proposée par exemple par Warren J.E. et al. (Réf. : "The Behavior of Naturally Fractured Reservoirs", SPE Journal (septembre 1963), 245-255). L'approche "double porosité" consiste à considérer le milieu fracturé comme deux continua de propriétés contrastées et échangeant des fluides entre eux : le continuum "fracture" (ou "fissure") constitué du réseau de fractures et le continuum "matrice" constitué des blocs matriciels, la réunion des deux continua constituant un "double milieu". Les simulateurs de réservoir reposant sur cette approche sont dits simulateurs à "double porosité" ou "double milieu".

### 3- Simulation des écoulements de fluides

#### *Principe*

A ce stade, l'ingénieur réservoir dispose d'une représentation géologique du gisement d'hydrocarbures fracturé, dont il souhaite extraire les hydrocarbures.

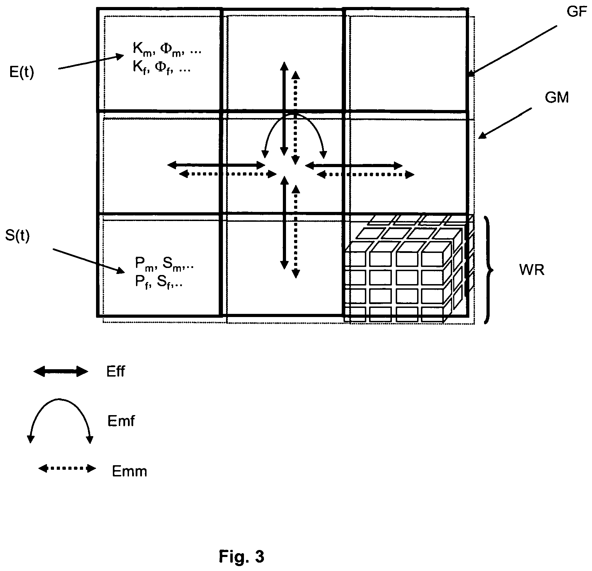

On utilise alors un outil bien connu des spécialistes : un simulateur de réservoir à double milieu. En référence à la figure 3, chacune des deux grilles (ensemble de mailles) de ce simulateur de réservoir est renseignée par des données d'entrées $E(t)$ qui concernent d'une part les propriétés (faciès lithologique, perméabilités ($K_m$, $K_f$), porosités ($\Phi_m$, $\Phi_f$), ...) liées à chacun des deux milieux "matrice" (pour la grille dite "matrice" - GM) et "fracture" (pour la grille dite "fissure" - GF), et d'autre part des propriétés liées aux fluides renfermés par ces deux milieux (masses volumiques, viscosités,...). Sur la figure 3, les échanges ($Eff$) au sein du milieu fracture sont représentés par une flèche rectiligne pleine, les échanges (Emm) au sein du milieu matrice sont représentés par une flèche rectiligne pointillée, et enfin, les échanges (Emf) entre le milieu matrice et le milieu fracture pour un couple de mailles donné, sont représentés par une flèche curviligne pleine. Les blocs matriciels sont représentés pour une maille $WR$.

Au moyen de ces informations, le simulateur détermine, en chaque maille, et pour chaque pas de temps $t$, divers paramètres $S(t)$, tels que la saturation ($S_m$, $S_f$) en huile ou en eau, les pressions ($P_m$, $P_f$) de ces phases huile et eau, leurs concentrations, la température, etc., suivant la nature du procédé de récupération (injection d'eau, de gaz, etc...). Pour ce faire, le simulateur résout deux ensembles d'équations couplées, un premier ensemble relatif au milieu matriciel, et un deuxième ensemble relatif au milieu fracturé. Ces deux jeux d'équations sont couplés, via un terme de flux, exprimant les transferts de masse et/ou d'énergie (dits "échanges matrice-fissure") entre la roche poreuse (blocs de matrice) et les fractures qui la traversent. Ce flux d'échange matrice-fracture ($f$) dépend de la différence de potentiel ($\Delta\Phi$) entre ces deux milieux, celle-ci s'exprimant comme une différence de pression, température, etc..., suivant la nature du processus physique d'échange mis en jeu par le procédé de récupération appliqué.

Selon la méthode de l'invention, le facteur de proportionnalité, appelé facteur d'échange, reliant le flux d'échange à la différence de potentiel matrice-fissure, est désormais directement déduit de la représentation géologique du réservoir (pour sa composante géométrique - voir ci-dessous). De plus, l'évolution au cours du temps de ce facteur (i.e. son caractère transitoire) est désormais prise en compte en utilisant cette même information géologique. Ce facteur d'échange permet de prendre en compte tous les phénomènes diffusifs en fonction du temps, liés à des modifications de pression, capillarité, température, ...

Le facteur de proportionnalité entre le flux ($f$) et la différence de potentiel ($\Delta\Phi$) dépend d'une part, des propriétés des fluides et du milieu matriciel mises en jeu par le phénomène diffusif considéré (par exemple, de la mobilité $\lambda_p$ du fluide et de la perméabilité de la matrice $K_m$ dans le cas d'un écoulement polyphasique d'une phase $p$ : $P_{mp}=K_m.\lambda_p$), d'autre part, d'un coefficient géométrique, noté $C$, décrit ci-après. Ce qui conduit à l'expression suivante du flux d'échange (de la phase $p$), exprimé par unité de volume de matrice :

$$f_p = C.P_{mp}.\Delta\Phi_p$$

Le coefficient géométrique $C$ représente le rapport entre l'aire d'échange et la distance d'échange entre les fractures d'une part, et les blocs matriciels d'autre part, ceci à l'échelle de la maille, ou volume élémentaire (hectométrique) de réservoir. Jusqu'alors exprimé à partir des dimensions d'un bloc dit "équivalent" à la représentation géologique et supposé invariable au cours du temps, il est désormais directement déduit des images géologiques du réservoir fracturé et évolue au cours du temps (*i.e.* est désormais transitoire) suivant les informations fournies par ces informations géologiques.

#### *Calcul du coefficient géométrique C. géologique et transitoire*

Cette étape consiste à déterminer, à partir du milieu poreux complexe construit à l'étape 2, des paramètres caractérisant des échanges transitoires (en fonction du temps, qui constitue une transition, le passage d'un état à un autre) entre les blocs matriciels et les fractures, pour toute maille du modèle et tout pas de temps de simulation.

Dans un premier temps, à titre d'exemple, on considère le cas d'échanges 2D au sein des couches, correspondant au cas de fractures sensiblement orthogonales aux limites de couches, avec une continuité capillaire du milieu matriciel entre couches. La généralisation de la méthode en trois dimensions est décrite ultérieurement.

Au sein d'une maille de dimensions $\Delta a$, $\Delta b$ et d'épaisseur $\Delta c$, le coefficient géométrique $C$ peut s'écrire de la façon suivante :

$$C = \Delta a \Delta b . I_A(X)$$

avec :

$X$ : distance de pénétration du fluide dans la maille à l'instant t considéré

$I_A(X)$ : facteur de forme géologique et transitoire (il s'agit du coefficient géométrique $C$ rapporté à l'unité d'aire de matrice). En se référant à la figure 2, on exprime le facteur de forme de la façon suivante :

$$I_A(X) = \frac{1}{\Delta a \Delta b} \frac{1}{\int_0^x \frac{dx}{P(x)}}$$

où $P(X)$ est le périmètre total (i.e. à l'échelle de la maille) du front d'échange parvenu à la distance $X$ de la limite de chacun des blocs de la maille considérée à l'instant considéré. $x$ est la variable distance : $0<x<X=X(t)$.

La figure 2 illustre, au sein d'une maille de dimensions $\Delta a$ et $\Delta b$, des blocs séparés par des fractures. Sur deux de ces blocs, les aires $A(X)$ de matrice envahie sont représentées par des hachures.

Le calcul des facteurs de forme géologiques et transitoires consiste à pré-calculer pour chaque maille de réservoir la fonction $I_A(X)$, X variant de 0 à $X_{max}$ ($X_{max}$ varie en fonction de la maille, et est connu puisqu'il s'agit de la borne supérieure des distances de pénétration X déterminées par traitement d'image de la représentation géologique du réseau de fractures observé en ce point du réservoir).

Pour calculer le facteur de forme $I_A(X)$, on note que :

$$P(x) = \frac{\partial A(x)}{\partial x} = A'(x)$$

Dans un premier temps, on traite donc l'image du réseau de fractures géologique de chaque maille de réservoir, afin d'obtenir la fonction A(X) pour chaque maille.

*Détermination de A(x), 0<x<X, 0<X<$X_{max}$*

Lors de la mise en production des hydrocarbures d'un gisement fracturé, les sollicitations (injection, soutirage) de ce dernier entraînent des modifications ("perturbations") de pression, saturation en fluides, etc... (suivant le procédé de récupération adopté) qui se propagent rapidement au sein du réseau de fractures (car très conducteur) : il en résulte un déséquilibre de pression, saturation, etc.. entre ces fractures et l'intérieur des blocs matriciels (peu conducteurs). Selon la modélisation du gisement en un milieu poreux complexe comportant un ensemble de blocs, la perturbation imposée à la limite de chaque bloc (fracture) se propage vers l'intérieur du bloc. La progression de cette perturbation est en première approximation assimilée à celle d'un front. Dans le cas d'un procédé de récupération par injection d'eau, il s'agirait d'un front de déplacement eau-huile. La distance séparant le bord d'un bloc et ce front est notée $x$. Considérant la section du bloc au sein de la ou de l'une des couches géologiques qui le contiennent, la surface envahie par ce fluide déplaçant divisée par l'aire totale de bloc à ce niveau est notée A, aire d'invasion normée. La relation reliant $A$ et $x$ est notée : $A(x)$. Cette fonction définit physiquement l'avancée du front au sein des blocs constitutifs du milieu fissuré. L'aire $A$ est une aire normée, i.e. rapportée à l'aire totale des sections des blocs contenus dans le volume élémentaire (cellule ou maille) du modèle de réservoir fracturé étudié.

Cette fonction A(x), relative aux blocs du milieu poreux complexe, est calculée par une technique de traitement d'image, appliquée à l'image représentative du réseau réel de fractures (milieu poreux complexe) reconstruite à l'échelle des unités élémentaires (mailles) du modèle de gisement considéré.

Différentes méthodes, connues des spécialistes, permettent de déterminer la fonction *A(x)*. On peut citer par exemple la méthode décrite dans le brevet FR 2.757.957 (US 6.064.944).

Les fissures étant définies par les coordonnées de leurs points limites sur une coupe bidimensionnelle XY d'une couche, le processus d'imbibition par lequel de l'eau est présente dans les fissures et de l'huile est présente dans les blocs matriciels doit être déterminé. On suppose que l'invasion de la matrice est de type piston. On admet que la fonction *x=f(t)* qui relie l'avancée du front (front eau-huile par exemple) au temps est la même pour tous les blocs matriciels, quelles que soient leurs formes et leurs tailles respectives. La fonction *A(x)* n'a pas d'expression analytique. Elle est calculée à partir d'une discrétisation de la coupe XY de la couche étudiée suivant l'algorithme défini ci-après.

La coupe XY de la couche étudiée est considérée comme une image dont chaque pixel représente un élément de surface. Ces pixels sont espacés régulièrement d'un pas dx dans la direction X et dy dans la direction Y. L'algorithme mis en oeuvre vise à déterminer, pour chaque pixel de cette image, la distance minimale qui le sépare de la fissure la plus proche.

L'image est traduite par un tableau de nombres réels à deux dimensions : Pict[0:nx+1, 0 :ny+1] où nx et ny sont les nombres de pixels de l'image dans les directions X et Y. En pratique, le nombre total de pixels (nx.ny) est par exemple de l'ordre du million. Les valeurs des éléments du tableau Pict sont les distances recherchées.

**Initialisation** : Tous les pixels par lesquels passe une fissure sont à une distance nulle de la fissure la plus proche. Pour ces pixels, le tableau Pict est donc initialisé à la valeur 0. Ceci est fait par un algorithme connu en soi (l'algorithme de Bresline par exemple) auquel on donne les coordonnées des pixels correspondants aux deux extrémités d'une fissure considérée comme un segment de droite et qui initialise (à 0 dans le cas présent) les pixels les plus proches. Les autres éléments de Pict sont initialisés à une valeur supérieure à la plus grande distance existant entre deux pixels de l'image. Cette valeur est par exemple nx.dx+ny.dy.

**Calcul** : Pour un pixel donné, le calcul de la distance recherchée à la fissure la plus proche se fait à partir des valeurs de distance déjà calculées pour les pixels voisins. On lui affecte une valeur qui, si elle s'avère inférieure à la valeur qui lui a été assignée initialement, est le minimum des valeurs des pixels voisins auxquelles on ajoute la distance de ces pixels à celui considéré.

Ce calcul est réalisé en deux phases successives. Lors de la passe descendante, on parcourt l'image ligne par ligne, de haut en bas et de gauche à droite (de Pict [1,1] à Pict [nx,ny]). Les pixels dont on tient compte sont différents selon que l'on est dans une passe descendante ou une passe montante.

L'écart oblique dxy étant défini comme : $dxy = \sqrt{dx^2 + dy^2}$, l'algorithme s'écrit

```
    pour j=1 à ny

|   pour i=1 à nx

|   |   Pict[i,j] =       min     Pict[i-1,j] + dx,        : passe descendante

|   |                             Pict[i-1,j-1] + dxy,

|   |                             Pict[i,j-1] + dy,

|   |                             Pict[i+1,j-1] + dxy,

|   |                             Pict[i,j]

|   fin de boucle sur i

fin de boucle sur j

    pour j=ny à 1,

|   pour i=1x à 1,

|   |   Pict[i,j] = minPict[i+1,j] + dx,        : passe descendante

|   |                             Pict[i+1,j+1] + dxy,

|   |                             Pict[i,j+1] + dy,

|   |                             Pict[i-1,j+1] + dxy,

|   |                             Pict[i,j]

|   fin de boucle sur i

fin de boucle sur j
```

**Histogramme** : A partir du tableau Pict ainsi calculé, on peut tracer un histogramme en classant les valeurs non nulles (celles affectées aux pixels hors des fissures) par ordre croissant.

Le cumulé de cet histogramme donne, pour toute distance délimitant deux intervalles de l'histogramme, le nombre de pixels non nuls dont la valeur est inférieure à cette distance. Dans l'application décrite à un milieu poreux fissuré où cette distance correspond à l'avancée du front d'eau, le cumulé de l'histogramme indique donc l'aire envahie par l'eau. La courbe $A(x)$ est obtenue en divisant ce cumulé par le nombre total de pixels non nuls (pour la normer). Le nombre d'intervalles utilisés en abscisse pour l'histogramme correspond au nombre de points de discrétisation de la courbe $A(x)$. On le choisit égal à 500 par exemple.

*Détermination de $I_A(X)$*

Pour chacune des valeurs de $x$ comprises entre 0 et X (X= distance séparant le front des limites des blocs (fractures) à l'instant considéré), la dérivée, $A'(x)$, de la fonction $A(x)$ par rapport à $x$ est calculée, et l'inverse de la fonction $A'(x)=P(x)$ est intégrée de 0 à $X$, ce qui conduit ainsi à un point de la fonction $I_A(X)$ de la maille considérée de dimensions $\Delta a$ et $\Delta b$ :

$$I_A(X) = \frac{1}{\Delta a \Delta b} \frac{1}{\displaystyle\int_0^X \frac{dx}{P(x)}}$$

## Simulation des écoulements

L'ingénieur réservoir choisit un procédé de production, par exemple le procédé de récupération par injection d'eau, dont il demeure ensuite à préciser le scénario optimal de mise en oeuvre pour le champ considéré. La définition d'un scénario optimal d'injection d'eau consistera, par exemple, à fixer le nombre et l'implantation (position et espacement) des puits injecteurs et producteurs afin de tenir compte au mieux de l'impact des fractures sur la progression des fluides au sein du réservoir.

En fonction du scénario choisi, de la représentation double milieu du gisement, et de la formule reliant le flux d'échange de masse et/ou d'énergie à la différence de potentiel matrice-fracture, on est alors capable de simuler la production d'hydrocarbures escomptée, au moyen du simulateur d'écoulement dit à double milieu.

A tout instant $t$ de la production simulée, à partir des données d'entrées $E(t)$ (données fixes ou variables au fur et à mesure du temps simulé), et de la formule reliant le flux $(f)$ d'échange à la différence de potentiel $(\Delta\Phi)$, le simulateur résout l'ensemble des équations propres à chaque maille et chacune des deux grilles du modèle (équations faisant intervenir la formule d'échange matrice-fissure décrite plus haut) et délivre ainsi les valeurs solutions des inconnues $S(t)$ (saturations, pressions, concentrations, température, ...) à cet instant $t$. De cette résolution, découle la connaissance des quantités d'huile produites et de l'état du gisement (distribution des pressions, saturations, etc...) à l'instant considéré. Toutefois, le flux d'échange transitoire, tel que décrit précédemment, fait intervenir des paramètres variables au cours du temps, et notamment la position du front $X(t)$ (distance séparant le bord des blocs et le front) à l'instant considéré $t$ :

$$f_p = C.P_{mp}.\Delta\Phi_p \qquad \text{avec :} \quad C = \Delta a \Delta b.I_A(X)$$

D'une part, à toute position $X$ du front de progression de la perturbation considérée (de pression, etc...) au sein des blocs, correspond une valeur fixée de l'aire envahie (ou perturbée) $A$. D'autre part, la valeur de l'inconnue (pression, saturation, etc...), $S$, décrivant l'état moyen des blocs du volume élémentaire du modèle est proportionnelle à la valeur, $A(X)$, de l'aire envahie (normée) à l'instant $t$ considéré. Ainsi, la variable inconnue $S$ normée entre 0 et 1 peut être assimilée à l'aire envahie $A$ (déjà normée suivant la définition qui en est donnée plus haut), soit finalement :

$$Sn(t) \approx A(X)$$

où $Sn(t)$ est la variable $S(t)$ normée, $X=X(t)$

Ainsi, à tout instant $t$ de simulation, la distance $X$ de pénétration du front d'échange au sein des blocs de la maille peut être reliée à l'inconnue $S(t)$ via la fonction inverse $A^{-1}$ (fonction connue à l'issue du traitement de l'image géologique du réseau de fractures) :

$$X(t) = A^{-1}(Sn(t))$$

On note toutefois que $Sn(t)$ est l'inconnue résolue par le simulateur au pas de temps $t$. En conséquence, deux modes de détermination de $X(t)$ peuvent être adoptés :

- détermination explicite de $X(t)$, i.e. à partir des inconnues résolues au pas de temps antérieur $(t-1)$,

- détermination implicite de $X(t)$, i.e. en même temps que les autres inconnues $S(t)$.

Nous décrivons ci-après l'approche explicite permettant la détermination de $X(t)$ et du flux d'échange matrice-fissure transitoire à chaque pas de temps de simulation, $t$, pour toute maille du modèle :

- calcul de $X(t)$ : ce calcul est effectué à partir de l'inconnue (état des blocs) normée au pas de temps précédent noté $(t-1)$ :

$$X(t) = A^{-1}(Sn(t-1))$$

- calcul de $I_A(X(t))$ :

$$I_A(X(t)) = \frac{1}{\Delta X \Delta Y} \frac{1}{\int_0^{X(t)} \frac{dx}{P(x)}}$$

où $X(t)$ est la borne supérieure d'intégration de la fonction $\dfrac{1}{P(x)} = \dfrac{1}{A'(x)}$

- calcul de $f_p$ :

$$f_p = C.P_{mp}.\Delta\Phi_p$$

avec : $C = \Delta a \Delta b . I_A(X(t))$

Afin de pouvoir initier la simulation suivant cette approche explicite, *i.e.* en vue de la résolution du premier pas de temps de production par le simulateur, $X$ doit être initialisé à une valeur très petite par rapport à $X_{max}$, mais non nulle.

Bien que ce calcul explicite (à partir des inconnues résolues au pas de temps précédent) puisse s'avérer suffisant (i.e. suffisamment précis), un calcul implicite est néanmoins possible. Dans ce cas, la variable $X(t)$ exprimée au pas de temps $t$, soit $X(t) = A^{-1}(Sn(t))$, est incorporée dans le système d'équations à résoudre à ce même pas de temps $t$. Plus précisément, on incorpore dans ce système la dérivée du flux d'échanges transitoires par rapport à l'inconnues $Sn$ du modèle, grâce à l'expression du facteur de forme géologique et transitoire $I_A(X(t))$ en fonction de la distance d'avancée $X(t)$, elle-même fonction de l'inconnue $Sn$ comme indiqué plus haut.

<u>4- Optimisation des conditions de production du gisement</u>

En sélectionnant divers scénarios, caractérisés par exemple par diverses implantations respectives des puits injecteurs et producteurs, et en simulant la production d'hydrocarbures pour chacun d'eux selon l'étape 3, on peut sélectionner le scénario permettant d'optimiser la production du gisement fracturé considéré suivant les critères technico-économiques sélectionnés.

**Généralisation au cas 3D.**

Dans le cadre d'échanges matrice-fissure s'opérant dans les trois directions de l'espace, le coefficient géométrique transitoire relatif aux échanges entre blocs matriciels et fractures s'écrit :

$$C = \Delta a \Delta b \Delta c . I_V(X)$$

avec $I_V(X)$, facteur de forme géologique et transitoire en 3D, s'exprimant comme :

$$I_V(X) = \frac{1}{\Delta a \Delta b \Delta c} \frac{1}{\int_0^x \frac{dx}{S(x)}}$$

où $S(X)$ est la surface totale (i.e. à l'échelle de la maille) du front d'échange parvenu à la distance $X$ de la limite de chacun des blocs de la maille considérée à l'instant (pas de temps) simulé.

De manière analogue au cas d'un échange à deux dimensions, on note que : $S(x) = \dfrac{\partial V(x)}{\partial x} = V'(x)$ où $V(x)$ est la fonction reliant le volume matriciel envahi (normé) à la distance de pénétration du fluide $x$. Cette fonction se calcule de façon analogue à la fonction $A(X)$ à partir de l'image géologique du réseau de fractures.

Ainsi, les fonctions $A(X)$ et $V(X)$ représentent chacune une relation représentant, pour une maille donnée, l'avancée d'un front d'échange au sein des blocs poreux, en fonction de la distance d'avancée $(X)$ du front. En deux dimensions, cette relation représente, pour une maille donnée, l'aire $A(X)$ de blocs poreux envahis par un fluide. En trois dimensions, cette relation représente, pour une maille donnée, le volume $V(X)$ de blocs poreux envahis par un fluide.

**Avantages**

La présente invention est donc une méthode alternative pour optimiser l'exploitation d'un gisement de fluide traversé par un réseau de fractures, dans laquelle on simplifie et fiabilise la prévision des échanges matrice - fractures par les simulateurs de réservoir fracturé (à double milieu).

Selon l'invention, les images des réseaux de fractures/failles issues de la description, caractérisation et/ou modélisation géologiques de réservoirs fracturés, sont désormais utilisées pour prédire les échanges entre les blocs poreux et les fractures au cours du temps, sans aucune simplification (« mise à l'échelle ») préalable de ces images, et en tenant compte du caractère graduel du changement d'état des blocs.

Ainsi, cette invention raccourcit et simplifie le processus d'intégration des informations géologiques en vue des prévisions de production.

L'invention rend également ces prévisions plus fiables et précises pour les deux raisons liées suivantes:

- l'information géologique relative à la distribution variée (complexe) des formes et dimensions des blocs est directement intégrée dans le simulateur de réservoir sans être dénaturée (i.e. approximée/modifiée) ;

- contrairement aux simulateurs à double porosité couramment utilisés, le caractère graduel ("transitoire") du changement d'état des blocs matriciels lors de la production est pris en compte, sur la base de la distribution réelle (géologique) des blocs de taille et forme variée.

Enfin, l'invention s'intègre dans le savoir-faire et les pratiques existantes, à savoir que le maillage et les équations générales du modèle d'écoulement, à double milieu dans le cas présent, sont préservés, ce qui satisfait la condition essentielle d'applicabilité de l'invention, à savoir la possibilité de fournir des résultats (prévisions de production nécessaires aux choix d'un procédé de récupération, du nombre/type de puits, etc...) pour des gisements de grande dimension et dans des délais réalistes (i.e. à l'issue de temps de calcul raisonnables). En effet, l'usage d'un maillage fidèle à la complexité géométrique du réseau de fractures réel serait inconcevable à l'échelle d'un réservoir de dimensions kilométriques.

De manière générale, l'invention permet de prévoir le comportement hydrodynamique (débit, pression,..) des champs fracturés (ou considérés et modélisés comme tels) en réponse à des sollicitations extérieures imposées via des puits lors de la production d'hydrocarbures.

Les ingénieurs en charge de l'exploitation du gisement ont alors un outil leur permettant de rapidement évaluer la performance de différents scénarios de production, et ainsi, de sélectionner celui qui optimise l'exploitation au regard des critères sélectionnés par l'opérateur, par exemple d'assurer une production d'hydrocarbure optimale en termes de débit et de récupération.

Ainsi, l'invention trouve une application industrielle dans l'exploitation de tout type de gisement souterrain traversé par un réseau de fractures. Il peut s'agir, par exemple, d'un gisement d'hydrocarbures pour lequel on souhaite optimiser la production, ou un gisement de stockage de gaz par exemple, pour lequel on souhaite optimiser l'injection ou les conditions de stockage.

**Revendications**

**1.** Méthode mise en œuvre par ordinateur pour optimiser l'exploitation d'un gisement de fluide traversé par un réseau de fractures, dans laquelle on discrétise ledit gisement en un ensemble de mailles, on associe à chacune desdites mailles une image représentative du réseau de fractures délimitant des blocs poreux et des fractures à partir d'observations directes et indirectes du gisement, la méthode comportant les étapes suivantes :

- on détermine, en chaque maille, un flux d'échanges transitoires intervenant entre les blocs poreux et les fractures, au moyen d'un traitement de ladite image représentative du réseau de fractures, à partir de l'estimation d'une relation ($A(X)$, $V(X)$) représentant, pour une maille donnée, une avancée d'un front d'échange au sein desdits blocs poreux, en fonction d'une distance d'avancée ($X$) dudit front et à partir des étapes suivantes :

• on calcule, à un pas de temps $t$, la distance d'avancée $X(t)$ dudit front, à partir de résultats de simulations des écoulements de fluide au pas de temps antérieur $t-1$, et de ladite relation ($A(X)$, $V(X)$) représentant l'avancée d'un front d'échange

• on calcule un facteur de forme géologique et transitoire $I_A(X(t))$, $I_V(X(T))$ en fonction de la distance d'avancée $X(t)$ dudit front et de ladite relation représentant l'avancée du front, ledit facteur de forme géologique et transitoire $I_A(X(t))$, $I_V(X(T))$ correspondant au coefficient géométrique C rapporté à l'unité d'aire ou de volume de roche poreuse, ledit coefficient géométrique C représentant le rapport entre l'aire A(X) ou le volume d'échange V(X), et la distance entre les fractures d'une part et les blocs poreux d'autre part à l'échelle de la

maille, l'aire A(X) ou le volume d'échange V(X) étant fonction de ladite distance d'avancée $X(t)$ dudit front ;
• on calcule ledit flux d'échanges transitoires à l'aide dudit facteur de forme,

- on simule des écoulements de fluides dans ledit gisement au moyen d'un simulateur d'écoulement et dudit flux d'échanges, et
- on optimise l'exploitation du gisement à l'aide de ladite simulation des écoulements de fluides.

**2.** Méthode selon la revendication 1, dans laquelle la relation représente, pour une maille donnée, une aire de blocs poreux envahis par un fluide.

**3.** Méthode selon la revendication 1, dans laquelle la relation représente, pour une maille donnée, un volume de blocs poreux envahis par un fluide.

**4.** Méthode selon l'une des revendications précédentes, dans laquelle on simule les écoulements de fluides, à partir d'un simulateur utilisant une méthode de résolution de type implicite, afin d'obtenir les résultats de simulation à chaque pas de temps t, en incorporant ledit flux d'échanges transitoires dans ladite méthode de résolution implicite au moyen des étapes suivantes :

- on exprime, à un pas de temps $t$, le flux d'échanges transitoires en fonction d'inconnues résolues par le simulateur à ce pas de temps $t$ ;
- on exprime une dérivée de ce flux d'échanges transitoires par rapport aux inconnues du simulateur, et
- on incorpore ladite dérivée dans un système d'équations dudit simulateur.

**Patentansprüche**

**1.** Computergestütztes Verfahren zur Optimierung der Nutzung einer Fluidlagerstätte, die von einem Bruchnetz durchquert wird, wobei die Lagerstätte in einen Satz von Maschen diskretisiert wird, mit jeder der Maschen ein Bild, welches für das Bruchnetz repräsentativ ist, das poröse Blöcke und Brüche begrenzt, aus direkten und indirekten Beobachtungen der Lagerstätte assoziiert wird, wobei das Verfahren die folgenden Schritte umfasst:

- in jeder Masche wird ein Strom vorübergehender Austausche, die zwischen den porösen Blöcken und den Brüchen stattfinden, mit Hilfe einer Verarbeitung des Bilds, welches für das Bruchnetz repräsentativ ist, aus der Schätzung einer Beziehung (A(X), V(X)), die für eine gegebene Masche eine Bewegung einer Austauschfront im Inneren der porösen Blöcke repräsentiert, als Funktion einer Distanz der Bewegung (X) der Front und aus den folgenden Schritten bestimmt:

• in einem Zeitschritt t werden die Bewegungsdistanz X(t) der Front aus Ergebnissen von Simulationen von Fluidströmungen in dem vorhergehenden Zeitschritt t-1 und die Beziehung (A(X), V(X)), welche die Bewegung einer Austauschfront repräsentiert, berechnet,
• ein geologischer und vorübergehender Formfaktor $I_A(X(t))$, $I_V(X(t))$ wird als Funktion der Bewegungsdistanz X(t) der Front und der Beziehung, welche die Bewegung der Front repräsentiert, berechnet, wobei der geologische und vorübergehende Formfaktor $I_A(X(t))$, $I_V(X(t))$ dem geometrischen Koeffizienten C in Bezug auf die Flächen- oder Volumeneinheit von porösem Gestein entspricht, wobei der geometrische Koeffizient C das Verhältnis zwischen der Austauschfläche A(X) oder dem Austauschvolumen V(X) und einerseits der Distanz zwischen den Brüchen und andererseits den porösen Blöcken im Maßstab der Masche repräsentiert, wobei die Austauschfläche A(X) oder das Austauschvolumen V(X) eine Funktion der Bewegungsdistanz X(t) der Front ist;
• der Strom vorübergehender Austausche wird mit Hilfe des Formfaktors berechnet,

- Fluidströme in der Lagerstätte werden mit Hilfe eines Strömungssimulators und des Austauschstroms simuliert, und

- die Nutzung der Lagerstätte wird mit Hilfe der Simulation der Fluidströme optimiert.

2. Verfahren nach Anspruch 1, wobei die Beziehung für eine gegebene Masche eine Fläche poröser Blöcke repräsentiert, die mit einem Fluid gefüllt sind.

3. Verfahren nach Anspruch 1, wobei die Beziehung für eine gegebene Masche ein Volumen poröser Blöcke repräsentiert, die mit einem Fluid gefüllt sind.

4. Verfahren nach einem der vorhergehenden Ansprüche, wobei die Fluidströmungen mit einem Simulator unter Verwendung einer Auflösungsmethode des impliziten Typs simuliert werden, um die Simulationsergebnisse zu jedem Zeitschritt t zu erhalten, indem der Strom vorübergehender Austausche in die implizite Auflösungsmethode mit Hilfe der folgenden Schritte eingeschlossen wird:

- zu einem Zeitschritt t wird der Strom vorübergehender Austausche als Funktion von Unbekannten ausgedrückt, die von dem Simulator zu diesem Zeitschritt t aufgelöst werden;
- eine Ableitung dieses Stroms vorübergehender Austausche wird in Bezug auf die Unbekannten des Simulators ausgedrückt; und
- die Ableitung wird in ein Gleichungssystem des Simulators eingeschlossen.

**Claims**

1. Computer-implemented method for optimizing the exploitation of a reservoir of fluid traversed by a fracture network, wherein said reservoir is discretized into a set of mesh cells, an image representative of the fracture network delimiting porous blocks and fractures being associated with each of said mesh cells on the basis of direct and indirect observations of the reservoir, the method comprising the following steps:

- a transient exchange flux occurring between the porous blocks and the fractures is determined, in each mesh cell, by means of processing of said image representative of the fracture network, based on estimation of a relationship ($A(X)$, $V(X)$) representing, for a given mesh cell, an advance of an exchange front within said porous *blocks, as a function of a distance of advance (*$X$*)* of said front, and by way of the following steps:

  • at a time $t$, the distance of advance $X(t)$ of said front is computed from results of simulations of fluid flows at the previous time $t$ - 1, and said relationship ($A(X)$, $V(X)$) representing the advance of an exchange front is computed,
  • a transient geological form factor $I_A(X(t))$, $I_V(X(t))$ is computed depending on the distance of advance of said front and on said relationship representing the advance of the front, said transient geological form factor $I_A(X(t))$, $I_V(X(t))$ corresponding to the geometric coefficient C divided by the unit area or volume of porous rock, said geometric coefficient C being the ratio between the exchange area $A(X)$ or the exchange volume $V(X)$ and the distance between on the one hand the fractures and on the other hand the porous blocks at the scale of the mesh cell, the exchange area $A(X)$ or the exchange volume $V(X)$ being dependent on said distance of advance $X(t)$ of said front;
  • said transient exchange flux is computed using said form factor,

- fluid flows in said reservoir are simulated by means of a flow simulator and of said exchange flux, and
- the exploitation of the reservoir is optimized using said simulation of the fluid flows.

2. Method according to Claim 1, wherein the relationship expresses, for a given mesh cell, an area of porous blocks invaded by a fluid.

3. Method according to Claim 1, wherein the relationship expresses, for a given mesh cell, a volume of porous blocks invaded by a fluid.

4. Method according to one of the preceding claims, wherein the fluid flows are simulated using a simulator employing a solving method of implicit type, in order to obtain, at each time $t$, simulation results, said transient exchange flux being incorporated into said implicit solving method by means of the following steps:

- at a time $t$, the transient exchange flux is expressed as a function of unknowns solved by the simulator at this time $t$;
- a derivative of this transient exchange flux is expressed with respect to the unknowns of the simulator, and
- said derivative is incorporated into a system of equations of said simulator.

**FIG. 1**

Fig. 2

E(t)

$K_m, \Phi_m, ...$
$K_f, \Phi_f, ...$

GF

GM

S(t)

$P_m, S_m, ...$
$P_f, S_f, ...$

WR

Eff

Emf

Emm

**Fig. 3**

**EP 2 072 752 B1**

## RÉFÉRENCES CITÉES DANS LA DESCRIPTION

**Documents brevets cités dans la description**

- EP 1158312 A
- US 2003216898 A
- FR 2757957
- US 6064944 A

**Littérature non-brevet citée dans la description**

- **WARREN J.E. et al.** The Behavior of Naturally Fractured Reservoirs. *SPE Journa,* Septembre 1963, 245-255
- **WARREN J.E. et al.** The Behavior of Naturally Fractured Reservoirs. *SPE Journal,* Septembre 1963, 245-255